**Europäisches Patentamt**

**European Patent Office**

**Office européen des brevets**

(19)

(11) Publication number: **0 072 690**
A2

(12)

# EUROPEAN PATENT APPLICATION

(21) Application number: **82304305.4**

(22) Date of filing: **16.08.82**

(51) Int. Cl.³: **H 01 L 21/90**
**H 01 L 23/52, H 01 L 27/02**

(30) Priority: **17.08.81 JP 128349/81**
**17.08.81 JP 128348/81**

(43) Date of publication of application:
**23.02.83 Bulletin 83/8**

(84) Designated Contracting States:
**DE FR GB**

(71) Applicant: **FUJITSU LIMITED**
**1015, Kamikodanaka Nakahara-ku**
**Kawasaki-shi Kanagawa 211(JP)**

(72) Inventor: **Shingu, Masataka**
**1, Saginuma 3-chome Takatsu-ku**
**Kawasaki-shi Kanagawa 213(JP)**

(72) Inventor: **Shirai, Kazunari**
**1310-4, Aza Kurinosawa Bukko-cho Hodogaya-ku**
**Yokohama-shi Kanagawa 240(JP)**

(74) Representative: **Skone James, Robert Edmund et al,**
**GILL JENNINGS & EVERY 53/64 Chancery Lane**
**London, WC2A 1HN(GB)**

(54) A MIS device and a method of manufacturing it.

(57) An MIS device having multilayer wiring has a lower layer wiring pattern (20c) connected to a gate electrode (16) of an MIS transistor and to an upper layer wiring pattern (23). The lower layer wiring pattern (20c) which is connected to the gate electrode (16) is also connected, at least partly during manufacture of the device, to a semiconductor substrate (11) via a protection element (17c) which has a conduction voltage smaller than the dielectric strength of the gate insulation film (15). Thus, the gate insulation film (15) is prevented from being destroyed by the electric charges that accumulate in the lower wiring layer (20c) connected to the gate electrode (16) during the formation of multilayer wiring.

*Fig. 2F*

- 1 -

FUJITSU LIMITED                    REF: 52/2014/02

## AN MIS DEVICE AND A METHOD OF MANUFACTURING IT.

The present invention relates to a metal-insulator-semiconductor (MIS) device. More specifically, it relates to the construction of an MIS device including multilayer wiring in which the gate insulation film is protected at least during formation of the device, and to a method for manufacturing it.

When the formation of an MIS integrated circuit device includes the step of connecting a plurality of wiring layers, the lower wiring layer which is connected to the gate of the semiconductor element electrically floats during the step of forming the multilayer wiring. Therefore, electric charges accumulate in the lower wiring layer due to certain factors, such as an impact caused by ions or radicals when the windows are formed in the interlayer insulation film by a dry-etching method such as reactive ion etching. When the potential of the lower wiring layer exceeds the dielectric strength of the gate insulation film, the electric charges are discharged through the gate insulation film to cause a permanent destruction of the gate insulation film and thus the element is destroyed.

It is conventional to protect the gate of a semiconductor element by connecting a diode between earth and another external gate electrode connection. However, a technique by which internally located MIS transistors are protected has not hitherto been proposed because each gate of such MIS transistors is usually connected to a source or drain region of at least one other device within the integrated circuit device and thus the pn junction between such region and the substrate shunts any overvoltage larger than its breakdown voltage.

In accordance with one aspect of the present invention a method of manufacturing an MIS device comprises the steps of forming an MIS transistor having a gate insulation film formed on a semiconductor substrate, a gate electrode on the gate insulation film, and source and drain regions in the substrate; providing a protection element forming region on the substrate; forming a lower layer wiring pattern on the substrate, the pattern having a gate wiring connected only to the gate electrode and to the substrate at the protection element forming region; forming a protection element; and forming an upper layer wiring pattern connected to the lower layer wiring pattern to form a connection between the gate electrode and another functional element, whereby the gate electrode is connected to the protection element at least up to the upper layer wiring pattern forming step.

With this method the internally located MIS elements are prevented from being destroyed by the parasitic charges accumulated during manufacture.

This method increases the production yield of MIS devices having a multilayer wiring structure.

Preferably, the protection element forming region is provided during the step of forming an MIS transistor.

In accordance with another aspect of the present invention, an MIS device having a multilayer wiring structure comprises a semiconductor substrate; an MIS transistor having a gate insulation film formed on the substrate and a gate electrode formed on the gate insulation film; a lower layer wiring pattern connected to the gate electrode of the MIS transistor; a protection element connected between the lower layer wiring pattern and the semiconductor substrate, at least during manufacture of the device, the protection element having a conduction voltage smaller than the dielectric strength of the gate insulation film of the MIS transistor; and an upper layer wiring pattern connected to the lower layer wiring pattern, whereby the lower layer wiring pattern is connected only to the gate electrode and the upper layer wiring pattern, and the protection element at least during formation of the device.

Some examples of methods and devices in accordance with the present invention will now be described with reference to the accompanying drawings, in which:-

Figure 1A is an equivalent circuit, and Figure 1B is a plan view, of a first example;

Figures 2A to 2F are diagrammatic, sectional views showing various stages in the manufacture of the device shown in Figure 1B;

Figure 3A is an equivalent circuit, and Figure 3B is a plan view, of a second example;

Figures 4A to 4F are diagrammatic, sectional views showing various stages in the manufacture of the device shown in Figure 3B;

Figure 5 is a plan view of a third example; and,

Figures 6A to 6E and 7A to 7E are diagrammatic, sectional views showing various stages in two alternative methods for manufacturing the device shown in Figure 5.

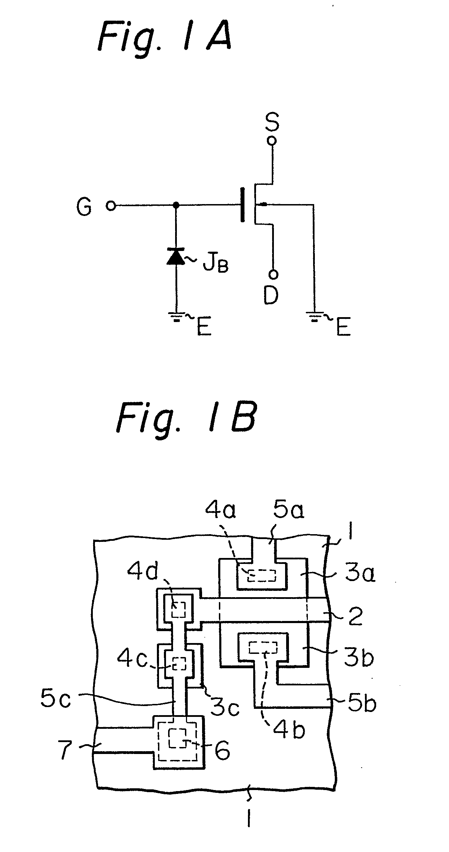

In the equivalent circuit of Figure 1A, the wiring connected to gate G is connected to a semiconductor substrate E via protecting PN junction $J_B$ having a reverse breakdown voltage which is smaller than the dielectric strength of the gate insulation film but larger than the gate threshold voltage of the MIS transistor to ensure its normal function. In the drawing, symbol S denotes the source, and D denotes the drain. Such a protection means is known in the art, although in the past it has been formed by a discrete component connected directly between the gate of a MIS transistor and earth to protect it from external electrostatic noise.

The present invention provides means for protecting the gate insulation film of internally located MIS transistors the gates of which do not have any direct connection to external leads of the device and which are connected only to lower wiring layers which do not have any direct connection to source or drain regions of MIS transistors.

Figure 1B is a plan view showing the construction of the MIS device according to one embodiment of the invention in which polycrystalline silicon gate electrode 2 is formed, through a gate oxide film, on a first region of a $P^-$-type silicon substrate that is patterned and exposed through field oxide film 1, and first $N^+$-type diffusion region 3a and second $N^+$-type diffusion region 3b, i.e., an $N^+$-type source region and an $N^+$-type drain region, are formed on the surface of the $P^-$-type silicon substrate that is exposed on both sides of gate electrode 2. Third $N^+$-type diffusion region 3c is formed in a second region of the $P^-$-type silicon substrate that is patterned and exposed through field oxide film 1. First, second, and third contact windows 4a, 4b, and 4c for exposing part of first, second, and third $N^+$-type diffusion regions 3a, 3b, and 3c and fourth contact window 4d for exposing part of polycrystalline silicon gate electrode 2 are formed on a first insulation film (lower insulation film) covering the substrate in which diffusion regions 3a, 3b, and 3c and gate electrode 2 are formed. On the first insulation film are formed lower source wiring 5a and lower drain wiring 5b, which are made of aluminum and are connected to first $N^+$-type diffusion region 3a or second $N^+$-type diffusion region 3b through contact window 4a or 4b, and lower gate wiring 5c, which is made of aluminum and is connected to polycrystalline silicon gate electrode 2 through contact window 4d and to third $N^+$-type diffusion region 3c through contact window 4c. All of these lower wirings 5a, 5b, 5c are formed by a first level aluminum layer. On the substrate having lower wirings 5a, 5b, and 5c, there is further formed a second insulation film, or interlayer insulation film, which has wire-connecting window (through hole) 6 allowing part of lower gate wiring 5c to be exposed. Upper wiring 7 made of a second level aluminum layer is formed on the interlayer insulation film so that it is connected to lower gate wiring 5c through window 6 through which a wire is connected (through hole).

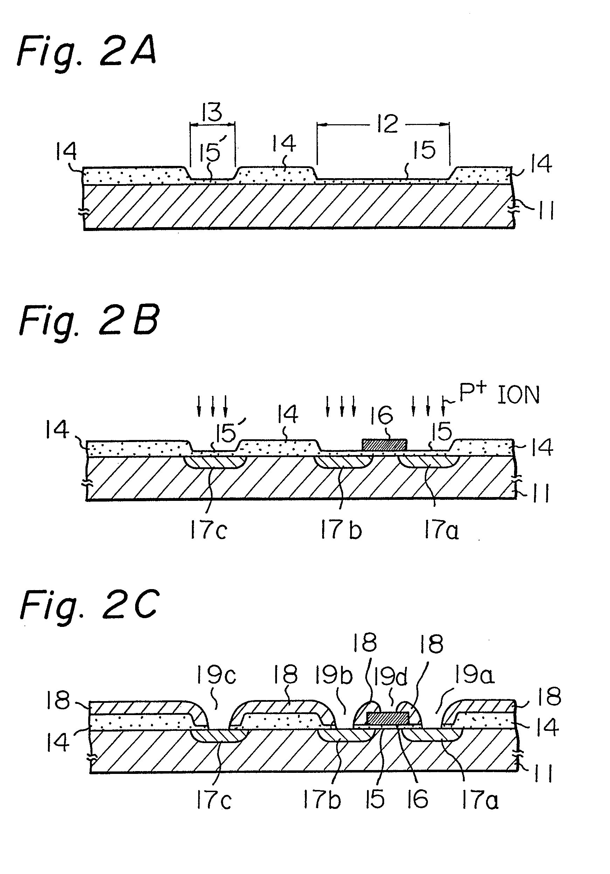

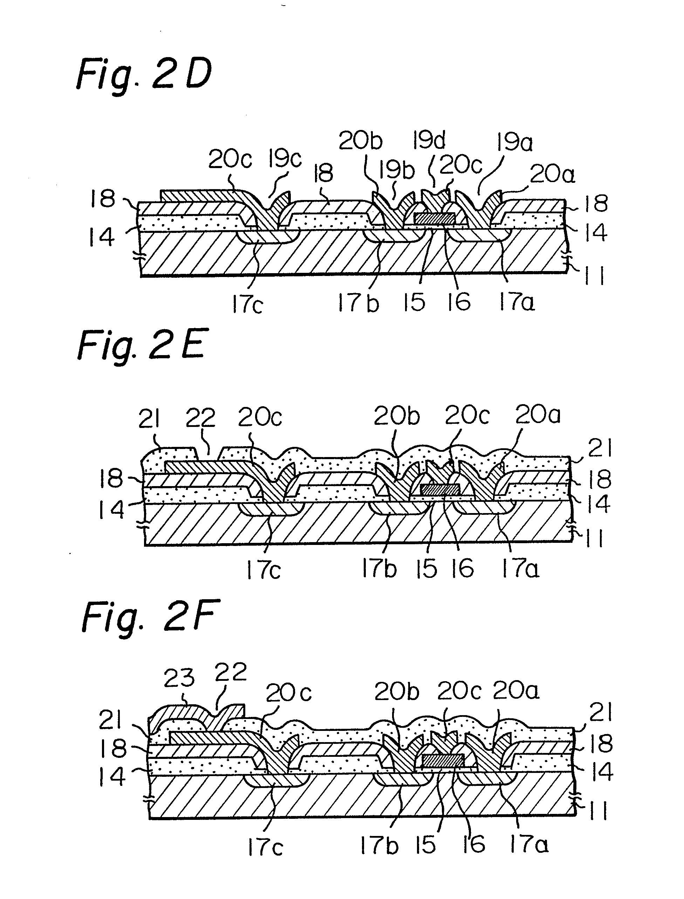

Figures 2A to 2F are processes for manufacturing an MIS device having the construction of the first embodiment. At first, field oxide film 14 having windows for exposing transistor-forming region 12 and protecting region 13 for forming a protecting element is formed on $P^-$-type silicon substrate 11 having a resistivity of about 20 [ohms/cm] as shown in Fig. 2A. Gate oxide film 15 having a thickness of about 500 angstroms is then formed on the surface of transistor-forming region 12 by a conventional thermal oxidation method. In this case, gate oxide film 15' having a thickness of about 500 angstroms is also formed on the surface of
protecting region 13. A polycrystalline silicon layer is
then allowed to grow to a thickness of about 4,000 angstroms
on the substrate by conventional chemical vapour deposition
(CVD) method and is subjected to patterning in conventional
manner to form polycrystalline silicon gate electrode 16 on
transistor-forming region 12 as shown in Fig. 2B. Then
phosphorus ions ($P^+$), in an amount of about $5 \times 10^{15}$
[atms/cm$^2$], are selectively injected into the surface of
$P^-$-type silicon substrate 11, with polycrystalline silicon
gate electrode 16 and field oxide film 14 used as masks.
In order to activate the region where the ions were injected,
the substrate is annealed at 1000°C. Thus, first $N^+$-type
diffusion region 17a and second $N^+$-type diffusion region 17b,
i.e., an $N^+$-type source region and an $N^+$-type drain region,
are formed in transistor-forming region 12 to a depth of
about 1 μm, and third $N^+$-type diffusion region 17c, i.e.,
an $N^+$-type diffusion region forming a protecting diode, is
formed in protecting element-forming region 13 to a thickness
of about 1 μm. Then a first insulation film, or lower
insulation film 18, composed of phosphorus silicate glass
(PSG) is formed on the substrate by a conventional CVD
method. Thereafter, first, second, and third contact
windows 19a, 19b, and 19c are formed in lower insulation
film 18 and in gate oxide films 15 and 15' by a wet-etching
method to expose the surface of source region 17a, the
surface of drain region 17b, and the surface of diffusion
region 17c as shown in Fig. 2C, and fourth contact window 19d
is formed to expose the surface of polycrystalline silicon
gate electrode 16. Aluminum is deposited on the substrate
to form a first level wiring layer having a thickness of
about 1 μm by a conventional evaporation method and is
subjected to patterning by a conventional method in order
to form source wiring 20a and drain wiring 20b which are
connected to source region 17a and drain region 17b through
contact windows 19a and 19b and to form gate wiring 20c
which is connected to gate electrode 16 and to protecting diode diffusion region 17c through contact windows 19d and 19c as shown in Fig. 2D. Lower gate wiring 20c on gate electrode 16 and gate wiring 20c in protecting connection diffusion region 17c are connected to each other in a region that is not diagrammed. After wiring 20a, 20b and 20c are formed, the individual connecting portions are ohmically connected by a conventional alloying process. Then a second insulation film, or interlayer insulation film 21, composed of PSG is formed on the substrate by a CVD method or a like method, and wire-connecting window (through hole) 22 is formed in interlayer insulation film 21 by a conventional dry-etching method to expose part of lower gate wiring 20c as shown in Fig. 2E. Thereafter, an aluminum layer of a thickness of about 1 μm is formed on the substrate by evaporation and is subjected to patterning by a conventional wet-etching method in order to form a second level wiring layer including upper gate wiring 23 on interlayer insulation film 21 which is connected to lower gate wiring 20c through wire-connecting window 22 as shown in Fig. 2F.

In the process of the above-mentioned embodiment, a PN junction formed between $N^+$-type diffusion region 17c and $P^-$-type silicon substrate 11 has a reverse breakdown voltage of about 20 to 30 volts, which is smaller than the dielectric strength of about 40 volts of gate oxide film 15. Therefore, in forming window 22 through which a wire is connected in interlayer insulation film 21 by a dry-etching method, for example, by reactive ion etching, any electric charge build-up in gate wiring 20c to a degree in excess of the reverse breakdown voltage of the PN junction is emitted into $P^-$-type silicon substrate 11 via protecting diode diffusion region 17c, and gate oxide film 15 is not destroyed. Further, since the reverse breakdown voltage of the PN junction is sufficiently greater than either the threshold voltage of the MIS transistor or the power-supply voltage of the semiconductor device, normal operation of the device is not hindered at all.

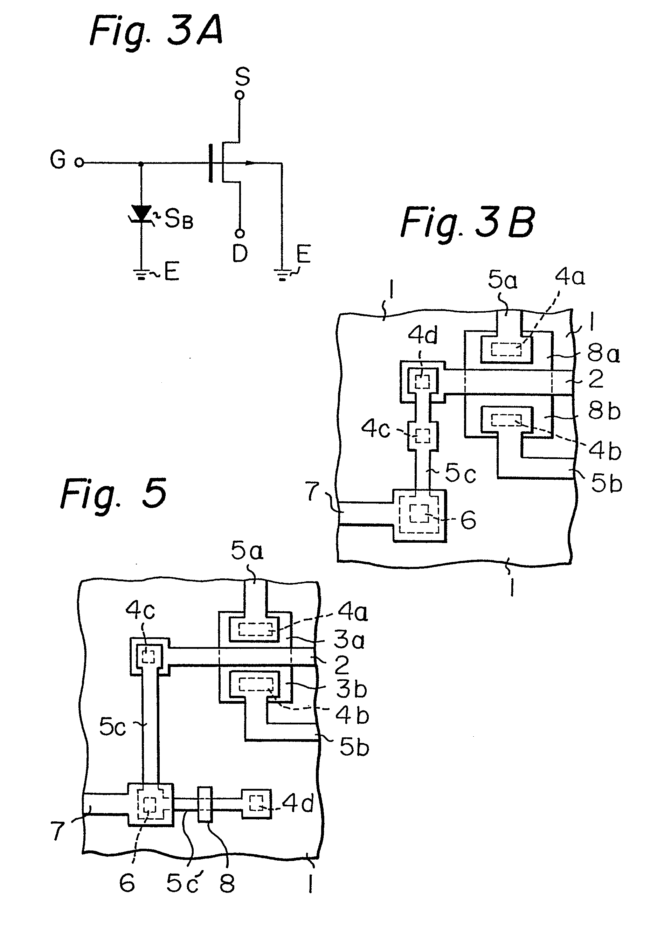

In the MIS device according to the second embodiment of the present invention as shown, for example, in the equivalent circuit of Fig. 3A, the wiring connected to gate G is connected to semiconductor substrate E via Schottky barrier $S_B$ which has a breakdown voltage that is smaller than the dielectric strength of the gate insulation film. In the drawing, S denotes the source, and D denotes the drain.

Figure 3B is a plan view showing the construction of such an MIS device in which polycrystalline silicon gate electrode 2 is formed, via a gate oxide film, on the first region of an $N^-$-type silicon substrate that is patterned and exposed through field oxide film 1, and first $P^+$-type diffusion region 8a and second $P^+$-type diffusion region 8b, i.e., a $P^+$-type source region and a $P^+$-type drain region, are formed on the surface of the $N^-$-type silicon substrate that is exposed on both sides of gate electrode 2. First contact window 4a and second contact window 4b for exposing part of first $P^+$-type diffusion region 8a and second $P^+$-type diffusion region 8b, third contact window 4c for exposing part of the $N^-$-type silicon substrate, and fourth contact window 4d for exposing part of polycrystalline silicon gate electrode 2, are formed in a first insulation film (lower insulation film) that covers the substrate in which diffusion regions 8a and 8b and gate electrode 2 are formed. On the first insulation film are formed lower source wiring 5a and lower drain wiring 5b which are made of aluminum and are connected to first $P^+$-type diffusion region 8a and second $P^+$-type diffusion region 8b through contact window 4a or 4b, and lower gate wiring 5c, which is made of aluminum and is connected to polycrystalline silicon gate electrode 2 through contact window 4d and to the $N^-$-type silicon substrate through third contact window 4c to form a Schottky barrier junction therewith. On the substrate having lower source wiring 5a, lower drain wiring 5b, and lower gate wiring 5c, there is further formed a second insulation film, or interlayer insulation film, which has window (through hole) 6 allowing part of lower gate wiring 5c to be exposed. Upper gate wiring 7 made of aluminum is formed on the interlayer insulation film so that it is connected to lower gate wiring 5c through wire-connecting window 6.

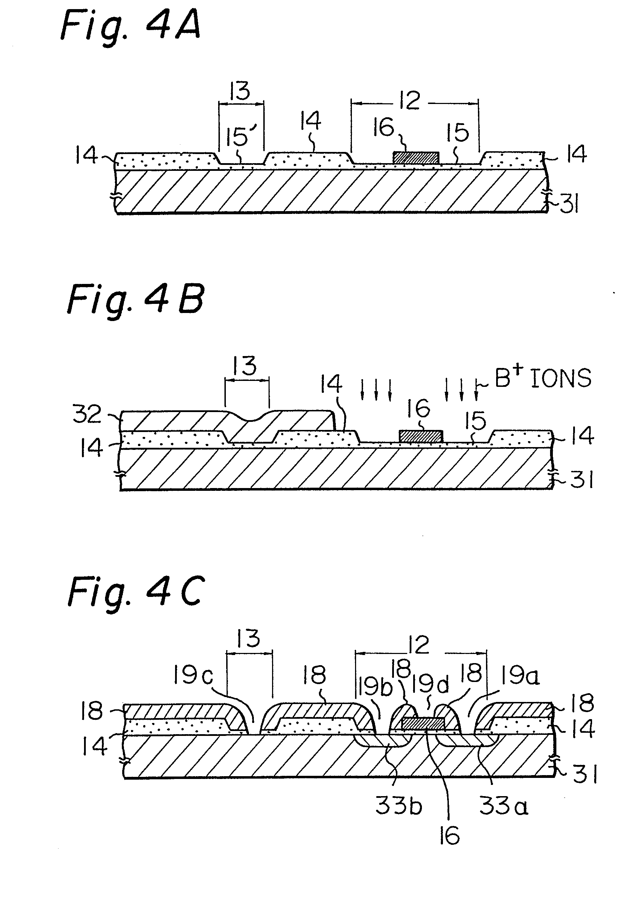

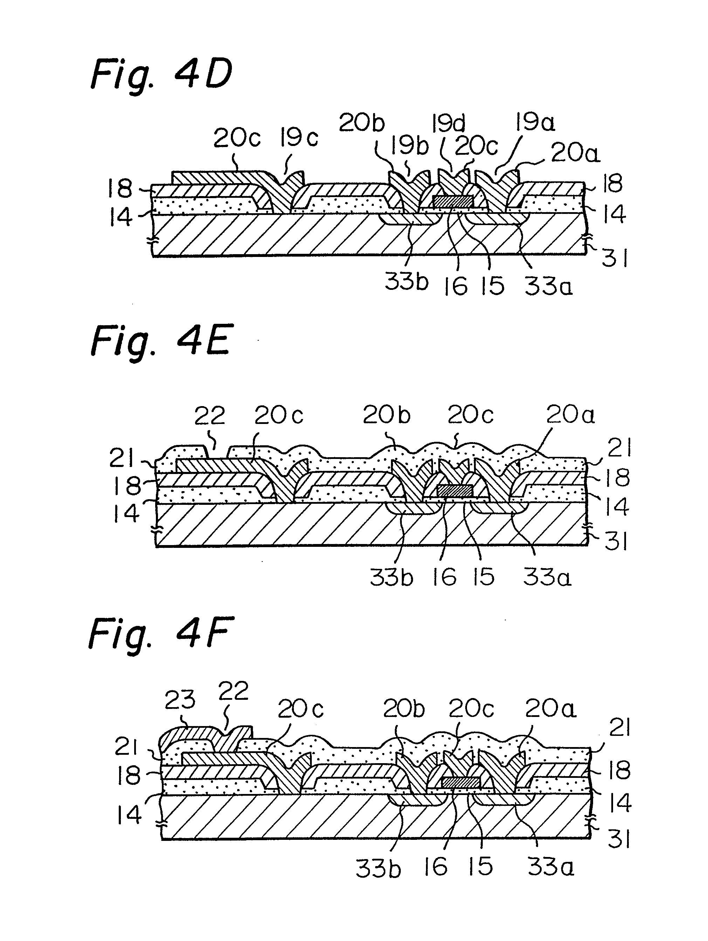

The process for forming a metal-oxide semiconductor (MOS) device having a construction according to the second embodiment is described below. In Fig. 4A, field oxide film 14 having windows for exposing transistor-forming region 12 and protecting region 13 is formed on $N^-$-type silicon substrate 31 which has a resistivity of about 1 [ohm-cm]. Then, like the process of the first embodiment, gate oxide film 15 having a thickness of about 500 angstroms is formed on the surface of transistor-forming region 12, and gate oxide film 15' having a thickness of about 500 angstroms is formed on the surface of protection connection--forming region 13. Moreover, polycrystalline silicon gate electrode 16 is formed on gate oxide film 15 to a thickness of about 4,000 angstroms. Thereafter, protecting region 13 is covered with photoresist film 32 as shown in Fig. 4B, boron ions $B^+$, in an amount of about $1 \times 10^{15}$ [atms/cm$^2$], are selectively injected into N-type silicon substrate 31 of transistor-forming region 12, using field oxide film 14 and gate electrode 16 as masks. Thereafter, photoresist film 32 is removed and the substrate is activated by heat treatment in order to form first $P^+$-type diffusion region 33a and second $P^+$-type diffusion region 33b, i.e., in order to form a $P^+$-type source region and a $P^+$-type drain region, in transistor-forming region 12 to a depth of about 1 μm, as shown in Fig. 4C. Then, like the process of the first embodiment, there is formed on the substrate a first insulation film, or lower insulation film 18, which has first, second, and third contact windows 19a, 19b, and 19c for exposing the surface of source region 33a, the surface of drain region 33b, and the surface of protecting region 13 of $N^-$-type silicon substrate 31 and which also has contact window 19d for exposing the surface of polycrystalline silicon gate electrode 16. In Fig. 4D, there are formed on lower insulation film 18 source wiring 20a and drain wiring 20b, which are made of a first level aluminum layer and are connected to source region 33a and drain region 33b through first and second contact windows 19a and 19b respectively, and gate wiring 20c, which is made of the first level aluminum layer and comes into contact with gate electrode 16 through fourth contact window 19d and into contact with N⁻-type silicon substrate 31 through third contact window 19c in the same manner as the process of the first embodiment. In the drawings, gate wiring 20c on gate electrode 16 and gate wiring 20c on protecting region 13 are connected to each other in a region that is not diagrammed. Then an interlayer insulation film consisting of PSG is formed on the substrate by a CVD method, and wire-connecting window (through hole) 22 is formed in interlayer insulation film 21 by the conventional dry-etching method so that part of gate wiring 20c is exposed as shown in Fig. 4E. Then, relying upon the same method as that of the first embodiment, a second level aluminum layer for upper wiring 23 is formed on interlayer insulation film 21 so that it is connected to gate wiring 20c through wire-connecting window 22 as illustrated in Fig. 4F.

According to the process of the above-mentioned embodiment, a Schottky barrier is formed in a portion of third contact window 19c between N⁻-type silicon substrate 31 and gate wiring 20c consisting of aluminum due to the alloying of aluminum and the N⁻-type silicon substrate when the interlayer insulation film is formed by heating. The Schottky barrier has a breakdown voltage of about 15 volts, which is smaller than the withstand voltage of gate oxide film 15. Therefore, any electric charge build-up in gate wiring 20c in excess of the breakdown voltage during the step of forming multilayer wiring is emitted into N⁻-type silicon substrate 31 via the Schottky barrier. Accordingly, gate oxide film 15 is not destroyed by the electric charge. Further, since the Schottky barrier has a breakdown voltage which is sufficiently greater than the power supply voltages of the semiconductor device, operation of the device is not hampered.

In these examples of the invention, the gate-protecting construction by the PN junction was explained in connection with an N-channel MOS (NMOS) device, and the gate-protecting construction by the Schottky barrier was explained in connection with the P-channel MOS (PMOS) device. Conversely, however, such constructions can be adapted to the PMOS device and the NMOS device, and can further be adapted to complementary metal-oxide semiconductor (CMOS) devices.

Protection by the Schottky barrier connection need not be limited to the use of aluminum only. For instance, titanium or molybdenum may be used as the lower wiring which is connected to the gate electrode. Further, the Schottky barrier may be composed of platinum silicide (PtSi) and aluminum may be deposited thereon by an evaporation method; i.e., the wiring is composed of aluminum, and the Schottky barrier is composed of PtSi. In this case, the breakdown voltage is about 10 volts. Here, the semiconductor substrate need not be limited to silicon only.

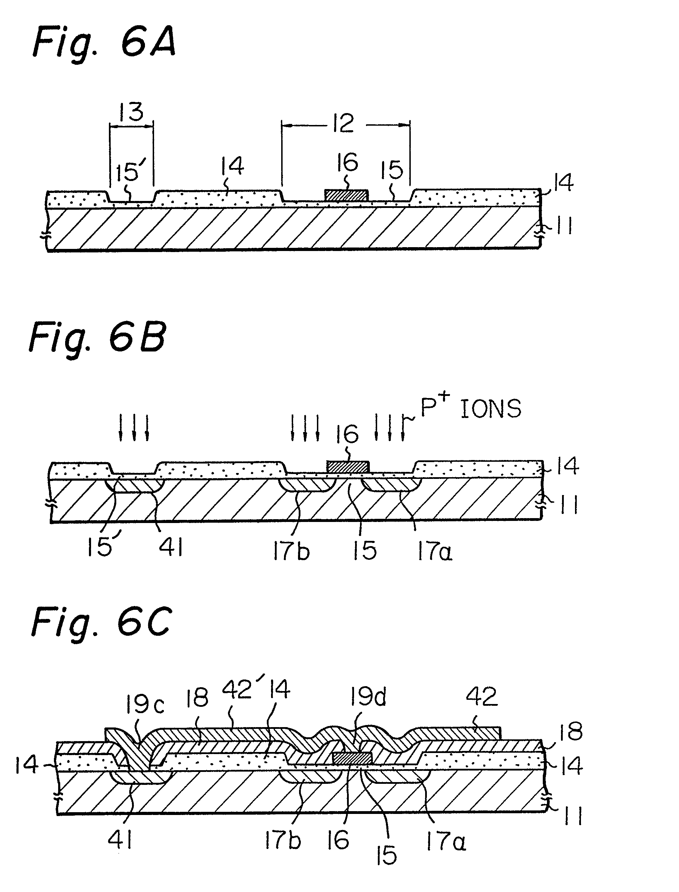

Figure 5 is a plan view of the construction of a third embodiment of the present invention. In the third embodiment shown in Fig. 5, contact windows 4a and 4b for source region 3a and drain region 3b and contact window 4c for gate electrode 2 are formed by a conventional method in a lower insulation film formed on a semiconductor substrate that has gate electrode 2 and source region 3a and drain region 3b formed therein. In this case, however, according to the third embodiment, contact window 4d is also formed in the semiconductor substrate (in which a diffusion region may be formed). On the lower insulation film, there are formed, by a conventional method, lower source wiring 5a, lower drain wiring 5b and lower gate wiring 5c to be connected to source and drain regions 3a, 3b and gate electrode 2 respectively through the contact windows. Here, gate wiring 5c is provided with branch wiring 5c', to be connected to the semiconductor substrate (or to the diffusion region formed in the substrate) via contact window 4d. In the interlayer insulation film formed on the substrate on which the lower source 5a, lower drain wiring 5b, and lower gate wiring 5c are formed, there is formed wire--connecting window (through hole) 6 which connects an upper wiring layer and the lower wiring layer. In this case, etching window 8 is formed simultaneously with the window 6 so that part of branch wiring 5c' of gate wiring 5c is exposed in a traverse. Then a layer of upper wiring material is formed on the interlayer insulation film by a conventional method and is subjected to selective etching in a conventional manner to form, on the interlayer insulation film, upper wiring layer 7 which is connected to gate wiring 5c through wire-connecting window 6. If the upper wiring material consists of aluminum, branch wiring 5c' of gate wiring 5c exposed through etching window 8 in the interlayer insulation film is selectively removed by the above etching so that lower gate wiring 5c which is connected to upper wiring layer 7 is separated from contact window 4d which is connected to the semiconductor substrate (or the diffusion region formed in the substrate). Instead, another etching process may be carried out to etch off the lower wiring 5c in the window after the patterning process of the upper wiring layer 7. A protective film or cover film is then formed in a conventional manner, thereby completing the MIS device.

In the previous examples the gate protection element is left permanently connected to the gate electrode. Two processes in which the gate protection element is disconnected will now be described.

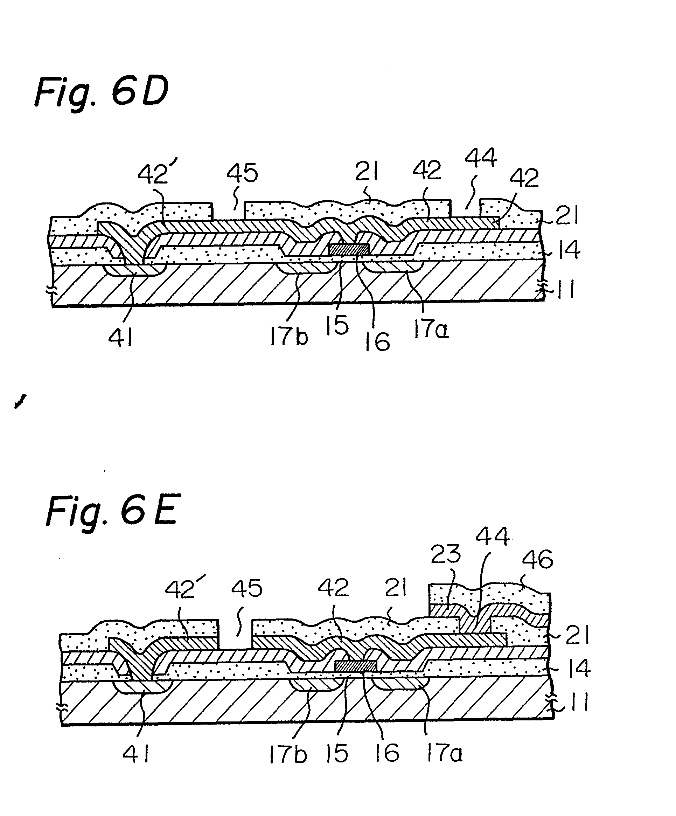

In the first example, field oxide film 14 is formed on, for example, $P^-$-type silicon substrate 11 according to a conventional method as shown in Fig. 6A, and windows are formed in field oxide film 14 to expose element-forming region 12 and protecting connection-forming region 13. Gate oxide film 15 and gate oxide film 15' are simultaneously formed on the above regions, and polycrystalline silicon gate electrode 16 is formed on gate oxide film 15. In Fig. 6B, N-type impurity ions (such as phosphorus ions $P^+$) are selectively injected into the surface of substrate 11, using gate electrode 16 and field oxide film 14 as masks, in order to activate the regions where the ions are injected and thereby formed $N^+$-type source region 17a and $N^+$-type drain region 17b in transistor-forming region 12 and $N^+$-type diffusion region 41 in protecting connection-forming region 13. In Fig. 6C, lower insulation film 18 composed of PSG or the like is formed on the substrate. Contact windows (not shown) for source region 17a and drain region 17b are formed in lower insulation film 18 by a conventional method, and contact windows 19c and 19d for polycrystalline silicon gate electrode 16 and for $N^+$-type diffusion region 41 are formed in lower insulation film 18. On lower insulation film 18 are formed, by a conventional method, source wiring and drain wiring (not shown) composed of aluminum, and gate wiring 42 having branch wiring 42' which is connected to gate electrode 16 through contact window 19d and to $N^+$-type diffusion region 41 through contact window 19c. In Fig. 6D, interlayer insulation film 21 composed of PSG or the like is formed on the substrate, and wire-connecting window 44 for gate wiring 42 and etching window (window for cutting the branch wiring) 45 are formed in interlayer insulation film 21. Then a layer of an upper wiring material such as aluminum film is deposited on the interlayer insulation film. In Fig. 6E, the upper aluminum film 23 is subjected to selective etching, with photoresist pattern 46 as mask, in order to form upper aluminum wiring layer 23 which is connected to gate wiring 42 through wire-connecting window 44. Then branch wiring 42' of gate wiring 42, which is composed of aluminum, in a region exposed through etching window 45 is removed simultaneously with the upper wiring material in the above selective etching to separate gate wiring 42 from $N^+$-type diffusion region 41. Note that the upper wiring layer 23 is necessarily connected to at least one source or drain. N$^+$ type region to incorporate the MIS transistor into the functional circuit, with the N$^+$ type region eventually functioning as a protective diode for the gate of the MIS transistor.

In the above-mentioned example, the electrical connection between gate wiring 42 of the lower layer wiring pattern and P$^-$-type silicon substrate 11 is maintained via a reverse junction, which is formed between N$^+$-type diffusion region 41 and P$^-$-type silicon substrate 11 and which has a breakdown voltage of about 20 to 30 volts, until the upper aluminum film, that is upper wiring layer 23, which is connected to gate wiring 42, is formed. In the step of forming the multilayer wiring, therefore, a high potential built up in the gate wiring is discharged into silicon substrate 11 via the junction of the N$^+$-type diffusion region. In other words, gate oxide film 15 is not destroyed by the parasitic electric charges. In this example, the protecting connection-forming region is formed in the P$^-$-type silicon substrate by diffusing N$^+$-type impurities. The protecting connection-forming region, however, may be formed by diffusing P$^+$-type impurities, using a photoresist film as a mask. In that case, the gate electrode and the P$^-$-type silicon substrate are coupled together by ohmic contact only during the manufacturing process. Even when the N$^-$-type silicon substrate is used, either the N$^+$-type impurities or the P$^+$-type impurities may be diffused to form the protecting connection-forming region.

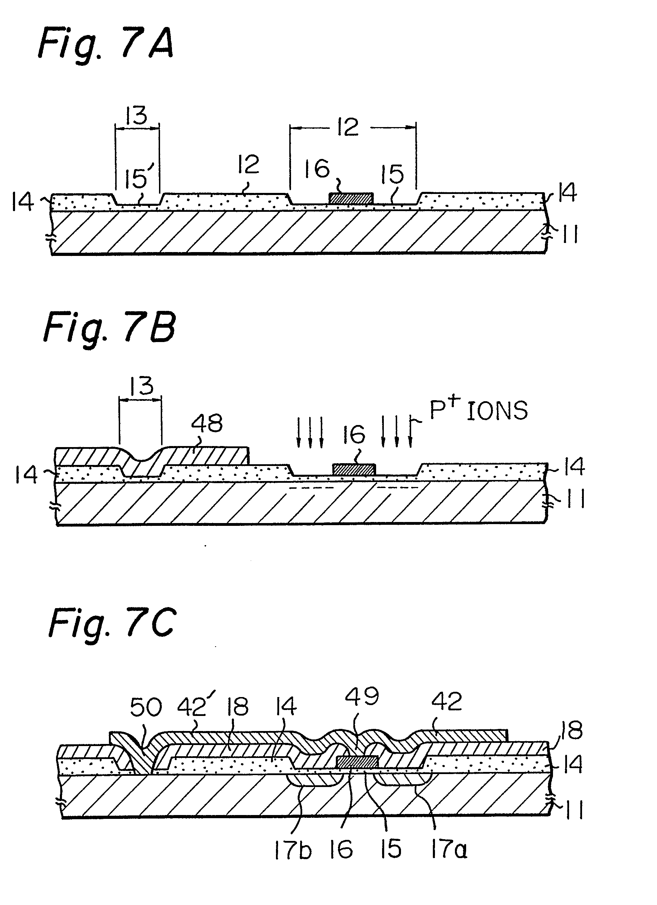

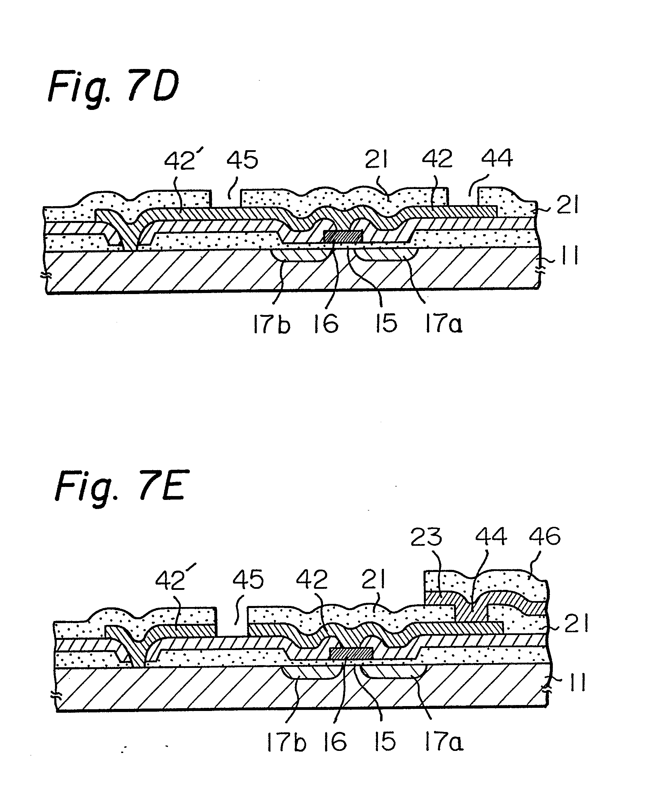

In the other example of the third embodiment, no junction is provided in the region where the gate wiring is electrically connected to the substrate. That is, in Fig. 7A, gate oxide film 15 is formed in transistor-forming region 12 of, for example, P$^-$-type silicon substrate 11, thin oxide film 15' is formed in protecting connection-forming region 13, field oxide film 14 is formed in other region, and polycrystalline silicon gate electrode 16 is formed on gate oxide film 15, according to the conventional method. In Fig. 7B, photoresist pattern 48 is formed to cover protecting connection-forming region 13, N-type impurity ions (such as phosphorus ions $P^+$) are selectively injected, and photoresist pattern 48 is removed, thereby forming $N^+$-type source region 17a and $N^+$-type drain region 17b. Next, lower insulation film 18 is formed on the substrate. In lower insulation film 18 are then formed contact windows (not shown) corresponding to source region 17a and drain region 17b and contact windows 49 and 50 corresponding to polycrystalline silicon gate electrode 16 and $P^-$-type silicon substrate 11, respectively. On lower insulation film 18 are further formed source wiring and drain wiring (not shown) composed of aluminum, and gate wiring 42 having branch wiring 42' which is connected to gate electrode 16, as well as to $P^-$-type silicon substrate 11. In Fig. 7D, interlayer insulation film 21 is formed on the substrate, and wiring-connecting window 44 for gate wiring 42 and etching window 45 are formed in interlayer insulation film 21. An aluminum film is then deposited on interlayer insulation film 21. In Fig. 7E, the upper aluminum film is subjected to selective etching, with the photoresist pattern 46 as a mask, to form upper aluminum wiring layer 23 which is connected to gate wiring 42 through wiring-connecting window 44. Then branch wiring 42' of gate wiring 42 is removed by selective etching in the region which is exposed through etching window 45 so as to separate gate wiring 42 from a branch wiring 42' that is connected to $P^-$-type silicon substrate 11. In this embodiment, branch wiring 42' of gate wiring 42 is ohmically connected to $P^-$-type silicon substrate 11. When an $N^-$-type silicon substrate is used, a Schottky barrier having a breakdown voltage of about 10 to 25 volts is formed in the connection portion. In either case, the electric charge accumulated in the gate wiring is allowed to discharge into the substrate via the connection portion at all times until the upper wiring layer is connected to the gate wiring. Accordingly, the gate oxide film is not destroyed by the parasitic electric charges.

Although the two examples above as the third embodiment were illustrated in the foregoing, it is in no way limited to the silicon substrate and to the aluminum wiring. Semiconductor substrates of any other compounds may be used, and any desired metal, such as titanium or molybdenum, may be used as a wiring material.

The third embodiment can, of course, be adapted to complementary MIS devices.

In manufacturing MIS devices having a multilayer wiring construction according to the present invention as mentioned in the foregoing, the gate insulation film is prevented from being destroyed by the electric charges that accumulate in the lower wiring layer connected to the gate electrode in the step of forming multilayer wiring. Consequently, productivity is increased. Further, in the third embodiment of the present invention, the region in which the lower wiring is connected to the substrate as well as to the gate, is separated from the gate wiring in the final step. Therefore, the wiring capacitance does not increase, and the operation speed of the elements does not decrease.

- 17 -

## CLAIMS.

1. A method of manufacturing an MIS device, the method comprising the steps of forming an MIS transistor having a gate insulation film (15) formed on a semiconductor substrate (11), a gate electrode (16) on the gate insulation film (15), and source and drain regions (17a, 17b) in the substrate (11); providing a protection element forming region (13) on the substrate (11); forming a lower layer wiring pattern on the substrate (11), the pattern having a gate wiring (20c) connected only to the gate electrode (16) and to the substrate (11) at the protection element forming region (13); forming a protection element; and forming an upper layer wiring pattern to form a connection between the gate electrode (16) and another functional element, whereby the gate electrode (16) is connected to the protection element at least up to the upper layer wiring pattern forming step.

2. A method according to claim 1, wherein the protection element forming region (13) is provided during the step of forming an MIS transistor.

3. A method according to claim 1 or claim 2, comprising the steps of forming a field insulation film (15,15') having windows for exposing a transistor-forming region (12) and a protection element forming region (13) on the semiconductor substrate (11);
forming the gate electrode (16) on the transistor-
forming region (12) and selectively introducing an
impurity into the surface of the substrate (11) at
the protection element forming region (13) and the
transistor-forming region (12) using the gate
electrode (16) as a mask so as to form a source
region (17a), a drain region (17b) and a protection
element region (17c); forming a lower insulation film
(18) on the field insulation film (15,15') and forming
contact windows (19a,19b,19c) at portions on the
source region (17a),the drain region (17b),the gate
electrode (16), and the protection element region (17c);
forming, on the lower insulation film, a lower layer
wiring pattern including a lower source wiring (20a),a
lower drain wiring (20b), and the lower gate wiring
(20c) which are connected via respective contact windows
(19a, 19b, 19d, 19c) to the source region (17a), the
drain region (17b), and between the gate electrode (16)
and the protection element region (17c) respectively;
forming, on the lower layer wiring pattern , a second
insulation film (21); forming on the second insulation
film (21), a wiring connection window (22) so as to
expose a part of the lower gate wiring (20c); and
connecting the upper layer wiring pattern (23) to the
lower gate wiring (20c) via the wiring connection
window (22).

4.    A method according to claim 1 or claim 2,
comprising the steps of forming a field insulation film
(15,15') having windows for exposing a transistor-
forming region (12) and a protection element-forming
region (13) on the semiconductor substrate; forming
the gate electrode (16) on the transistor-forming
region (12) and forming a masking film (32) on the
protection element forming region (13); selectively injecting impurity ions into the transistor forming region (12) using the gate electrode (16) as a mask, so as to form a source region and a drain region; forming a lower insulation film (18) on the substrate (11) and forming contact windows (19a, 19b,19d, 19c) at portions on the source region (17a), the drain region (17b), the gate electrode (16), and the protection element-forming region (17c) respectively; forming, on the lower insulation film, a lower layer wiring pattern including a lower source wiring (20a), a lower drain wiring (20b) and the lower gate wiring (20c) which are connected via respective contact windows to the source region (17a),the drain region (17b), and between the gate electrode (16) and the protection element-forming region (13) respectively; forming, on the lower layer wiring pattern,a second insulation film (21); forming in the second insulation film (21), a wiring connection window (22) so as to expose a part of the lower gate wiring (20c); and connecting the upper layer wire pattern (23) to the lower gate wiring (20c) via the wiring connection window (22).

5. A method according to any of claims 1 to 4, wherein the protection element is disconnected from both the gate electrode (16) and the upper layer wiring pattern (23) during or after the upper layer wiring pattern (23) forming step.

6. A method according to claim 5, wherein the protection element is disconnected during connection of the upper layer wiring pattern (23) to another functional element.

7. A method according to claim 5 or claim 6, when dependant on claim 3 or claim 4, wherein the wiring connection window (22) is formed in the second insulation film (21) at a position such that the upper layer wiring pattern (23) is connected to the lower gate wiring (20c) between the gate electrode (16) and the protection element, the method further comprising forming an etching window (45) in the second insulating film (21); and etching selectively via the etching window (45) a portion of the lower gate between the upper/lower wiring pattern connection and the protection element region (13) to disconnect the gate electrode (16) from the protection element.

8.    An MIS device having a multilayer wiring structure, the device comprising a semiconductor substrate (11); an MIS transistor having a gate insulation  film (15) formed on the substrate (11) and a gate electrode (16) formed on the gate insulation film (15);  a lower layer wiring pattern (20c) connected to the gate electrode (16) of the MIS transistor; a protection element (17c) connected between the  lower layer wiring pattern (20c) and the semiconductor substrate (11), at least during manufacture of the device, the protection element (17c) having a conduction voltage smaller than the dielectric strength of the gate insulation film (15) of the MIS transistor; and an upper layer wiring pattern (23) connected to the  lower layer wiring pattern (20c), whereby the lower layer wiring pattern (20c) is connected only to the gate electrode (16) and the upper layer wiring pattern (23), and the protection element (17c) at least during formation of the device.

9.    An MIS device according to claim 8, wherein the protection element (17c) comprises a reverse junction formed between the lower layer wiring pattern (20c) and the semiconductor substrate (11) of the MIS device.

10.    An MIS device according to claim 8, wherein the protection element comprises a Schottky barrier formed between the lower layer wiring pattern (20c) and the semiconductor substrate (11) of the MIS device.

Fig. 1 A

Fig. 1 B

## Fig. 2A

## Fig. 2B

## Fig. 2C

## Fig. 2 D

## Fig. 2 E

## Fig. 2 F

Fig. 3A

Fig. 3B

Fig. 5

## Fig. 4A

## Fig. 4 B

## Fig. 4 C

*Fig. 4D*

*Fig. 4E*

*Fig. 4F*

*Fig. 6A*

*Fig. 6B*

$P^+$ IONS

*Fig. 6C*

## Fig. 6D

42′  45  21  42  44  42
21
14
11
41  17b  15  16  17a

## Fig. 6E

42′  45  42  21  23  44  46
21
14
11
41  17b  15  16  17a

## Fig. 7A

## Fig. 7B

P⁺ IONS

## Fig. 7C

## Fig. 7D

42'  45          21   42   44

21

11

17b  16   15  17a

## Fig. 7E

23   44  46

42'   45   42   21

21

11

17b  16   15  17a